# FASCICULE DE BREVET EUROPEEN

(11) **EP 2 279 290 B1**
(45) Date de publication et mention de la délivrance du brevet: **17.12.2014**
(21) Numéro de dépôt: 09750032.6
(22) Date de dépôt: 04.05.2009
(51) Int. Cl.: C25D 3/38, C25D 7/12, C25D 5/54, H01L 21/768, H01L 21/288, H05K 3/42

(54) **COMPOSITION D'éLECTRODEPOSITION ET PROCéDé DE REVÊTEMENT D'UN SUBSTRAT SEMI-CONDUCTEUR UTILISANT LADITE COMPOSITION**
ELEKTROPLATTIERUNGSZUSAMMENSETZUNG UND VERFAHREN ZUR BESCHICHTUNG EINES HALBLEITERSUBSTRATS MIT BESAGTER ZUSAMMENSETZUNG
ELECTROPLATING COMPOSITION AND PROCESS FOR COATING A SEMICONDUCTOR SUBSTRATE USING SAID COMPOSITION

(30) Priorité: 05.05.2008 FR 0852970; 02.10.2008 US 194977
(43) Date de publication de la demande: 02.02.2011
(73) Titulaire: Alchimer, 91300 Massy (FR)
(72) Inventeur: ZAHRAOUI, Saïd, F-91600 Savigny Sur Orge (FR); RAYNAL, Frédéric, F-75012 Paris (FR)
(74) Mandataire: Hubert, Philippe
(86) Numéro de dépôt international: PCT/FR2009/050812
(87) Numéro de publication internationale: WO 2009/141551

(56) Documents cités:
- EP-A- 1 479 793
- WO-A-2007/034117
- WO-A-2007/096390
- US-A1- 2007 068 820
- US-B1- 6 197 181

## Description

La présente invention concerne généralement une composition d'électrodéposition destinée au revêtement d'une surface d'un substrat par du cuivre, notamment d'une surface constituée d'un matériau électriquement résistif, et en particulier au revêtement d'une couche barrière de diffusion au cuivre.

L'invention trouve essentiellement application dans le domaine de la microélectronique pour la métallisation de vias traversants (dénommés « through silicon vias » ou « through wafer vias » ou « through wafer interconnect » en anglais) clef de voûte de l'intégration des puces électroniques (dénommées « chip » ou « die » en anglais) en trois dimensions (3D) ou intégration verticale. Elle trouve également application dans d'autres domaines de l'électronique où un substrat comportant des vias traversants et une couche formant barrière de diffusion au cuivre doit être recouvert d'une couche de cuivre. On citera dans ce contexte la fabrication d'éléments d'interconnexion dans des circuits imprimés (dénommés « printed circuit board » ou « printed wire board » en anglais) ou celle d'éléments passifs, tels que les inductances, ou électromécaniques dans des circuits intégrés ou des microsystèmes (dénommés « micro electro mechanical systems » en anglais).

Les systèmes électroniques actuels se composent, pour la plupart, de plusieurs circuits intégrés, ou composants, et chaque circuit intégré remplit une ou plusieurs fonctions. Par exemple, un ordinateur comporte au moins un microprocesseur et plusieurs circuits mémoires. Chaque circuit intégré correspond usuellement à une puce électronique dans son propre boîtier (dénommé « package » en anglais). Les circuits intégrés sont brasés ou enfichés sur, par exemple, un circuit imprimé (dénommé « printed circuit board » ou « PCB » en anglais) qui assure la connexion entre les circuits intégrés.

Depuis plusieurs générations de circuits intégrés, le besoin permanent d'augmenter la densité de fonctionnalité conduit à concevoir les systèmes selon le concept du « système sur puce » (dénommé « system on chip » en anglais). Tous les composants et blocs de circuit nécessaires à la mise en oeuvre de l'ensemble des fonctions du système sont alors réalisés sur la même puce, sans utiliser le support d'un circuit imprimé. En pratique, il est néanmoins très difficile d'obtenir un « système sur puce » de haute performance car les procédés de fabrication des circuits logiques et mémoires, par exemple, diffèrent très substantiellement.

L'approche « système sur puce » aboutit donc à consentir des compromis quant aux performances des différentes fonctions réalisées sur la même puce. De plus la taille de telles puces et leur rendement de fabrication atteignent les limites de leur faisabilité économique.

Une autre approche consiste à fabriquer dans un même boîtier un module assurant l'interconnexion de plusieurs circuits intégrés, lesquels peuvent alors provenir du même substrat semi-conducteur ou de substrats différents. Le boîtier ainsi obtenu ou « module multi puce » (dénommé « multi chip module » ou « MCM » en anglais) se présente ainsi sous la forme d'un composant unique. Il existe différentes technologies de substrat « MCM » e.g. laminé, céramique. Dans tous les cas l'approche « MCM » permet d'obtenir une plus haute densité d'interconnexion et donc une meilleure performance qu'une approche « PCB » classique. Néanmoins elle ne s'en distingue pas fondamentalement. Outre l'encombrement et le poids du boîtier, les performances d'un « MCM » restent limitées par les éléments parasites associés à la longueur des connexions du substrat et aux fils de connexion (dénommés « wire bonding » en anglais) reliant le substrat ou les puces aux broches (dénommées « pins » en anglais) du boîtier.

Grâce à la mise en oeuvre d'une intégration en trois dimensions (3D) ou intégration verticale, les puces sont superposées (dénommé « stacked » en anglais) et reliées entre elles par des interconnexions verticales. L'empilement obtenu comporte plusieurs couches ou strates de composants actifs ou puces, il constitue un circuit intégré en trois dimensions (dénommé « 3D integrated circuit » ou « 3D IC » en anglais).

Les bénéfices de l'intégration 3D relèvent à la fois :
(1) de l'amélioration des performances e.g. réduction du temps de propagation et de la puissance dissipée, augmentation de la rapidité de fonctionnement du système associée à la communication accélérée entre les blocs fonctionnels, augmentation de la bande passante de chaque bloc fonctionnel, augmentation de l'immunité au bruit,
(2) de l'amélioration des coûts e.g. augmentation de la densité d'intégration, meilleur rendement de fabrication grâce à l'emploi de la génération de puce électronique la plus appropriée à chaque bloc fonctionnel, amélioration de la fiabilité, et
(3) de la possibilité de réaliser des systèmes hautement intégrés par l'empilement de technologies hétérogènes (ou co-intégration) i.e. mettant en jeu différents matériaux et/ou différents composants fonctionnels.

Aujourd'hui l'intégration 3D se révèle une alternative indispensable aux approches conventionnelles, qui atteignent leurs limites en termes de performance, de diversification des fonctionnalités et de coût de réalisation. Après empilement, par exemple par collage, les puces peuvent être individuellement connectées aux broches du boîtier par des fils de connexions. Néanmoins l'interconnexion des puces entre elles avec une densité d'interconnexion élevée ne peut être obtenue que par la mise en oeuvre de vias traversants. Les fondements et avantages de l'intégration 3D ont été décrits par exemple dans : A.W. Topol, D.C. La Tulipe, L. Shi, D.J. Frank, K. Bernstein, S.E. Steen, A. Kumar, G.U. Singco, A.M. Young, K.W. Guarini et M. Leong, "Three-dimensional integrated circuits" IBM Journal Res. & Dev., vol. 50, N° 4/5, July/September 2006, pages 491-506.

L'amincissement des tranches de silicium (dénommées "wafers" en anglais), l'alignement entre les couches, le collage (dénommé « bonding » en anglais) des couches, la gravure et la métallisation des vias traversants au sein de chaque couche sont les technologies élémentaires nécessaires à la réalisation de circuits intégrés en trois dimensions.

Les circuits en trois dimensions peuvent être réalisés en amincissant la tranche de silicium avant la fabrication des vias traversants (e.g. U.S. Patent Nos 7,060,624; 7,148,565).

La gravure et la métallisation des vias peuvent aussi se faire avant amincissement de la tranche de silicium (e.g. U.S. Patent No 7,060,624; 7,101,792). Dans ce cas les vias sont gravés dans le silicium, puis métallisés jusqu'à la profondeur souhaitée avant d'amincir la tranche de silicium. Lors de leur métallisation les vias sont donc fermés ou « borgnes » (dénommés « blind vias» en anglais).

La bonne conductivité électrique du cuivre et sa résistance élevée au phénomène d'électromigration, c'est-à-dire la faible migration des atomes de cuivre sous l'effet de la densité de courant électrique susceptible d'être une cause importante de défaillance, en font en particulier un matériau de choix pour la métallisation des vias traversants.

Les vias traversants sont généralement réalisés de façon similaire au « procédé Damascene » (utilisé dans le domaine de la microélectronique pour la fabrication d'éléments d'interconnexion des circuits intégrés) selon une succession d'étapes comportant :
- la gravure des vias dans ou au travers de la tranche de silicium ;
- le dépôt d'une couche diélectrique isolante (généralement constituée d'oxyde ou de nitrure de silicium, par exemple) ;
- le dépôt d'une couche barrière ou « liner » (généralement constituée de tantale (Ta), titane (Ti), nitrure de tantale (TaN), nitrure de titane (TiN), titanate de tungstène (TiW), nitrure ou carbure de tungstène (WCN) ou de combinaisons de ces matériaux, par exemple) servant à empêcher la migration du cuivre ;
- le dépôt d'une mince couche de cuivre métallique, appelée couche de germination ("seed layer" en anglais) ;
- le remplissage des vias par électrodéposition de cuivre ; et
- l'élimination du cuivre en excès par polissage mécano-chimique.

Les étapes de dépôt de la couche barrière, de la couche de germination, de remplissage et de polissage du cuivre constituent la métallisation des vias traversants.

La couche barrière présente généralement une résistance trop élevée pour permettre, par voie électrochimique directe, un dépôt de cuivre homogène ou uniforme à l'échelle de la tranche, phénomène connu de l'homme de l'art sous le terme de chute ohmique. La résistance élevée de la couche barrière résulte de la résistivité élevée des matériaux la constituant (par exemple nitrures métalliques).

Il est de ce fait nécessaire, préalablement à l'étape de remplissage par électrodéposition du cuivre, de recouvrir la couche barrière - par une méthode non électrochimique - d'une mince couche de cuivre métallique, appelée couche de germination.

Cette couche de germination, comme la couche barrière, est actuellement réalisée par des procédés de dépôt physique ou chimique à partir d'une phase vapeur (PVD ou "Physical Vapor Deposition" et CVD ou "Chemical Vapor Deposition" en anglais, respectivement).

Le dépôt chimique en phase vapeur (CVD) permet d'obtenir une couche de cuivre conforme, c'est-à-dire épousant fidèlement la topographie de la surface à revêtir, et ceci pour une large gamme de facteurs de forme (« aspect ratio » en anglais).

Cependant, les couches de cuivre formées par dépôt chimique en phase vapeur présentent une adhérence médiocre sur les barrières de diffusion. Ceci limite en pratique l'intérêt de ce type de procédé dans la mesure où une forte adhérence entre le cuivre et la barrière est requise afin d'assurer la fiabilité des vias traversants.

De plus, les procédés utilisant un dépôt chimique en phase vapeur sont relativement coûteux en raison du prix élevé des consommables (précurseurs), de l'équipement nécessaire à leur mise en oeuvre et de leur faible rendement.

Le dépôt physique en phase vapeur (PVD) est actuellement préféré d'un point de vue industriel dans la mesure où il permet de revêtir des surfaces ayant une résistivité élevée avec une adhérence du cuivre sur la barrière bien meilleure que celle obtenue avec les procédés de type CVD.

L'épaisseur du revêtement déposé par PVD est directement proportionnelle à l'angle solide vu de la surface à revêtir. De ce fait, les parties de la surface présentant des angles saillants sont recouvertes d'une couche plus épaisse que les parties de la surface présentant des angles rentrants. Il en résulte que les couches de germination de cuivre formées par dépôt physique en phase vapeur ne sont pas conformes, et ne présentent donc pas une épaisseur uniforme en tout point de la surface du substrat.

En particulier les circuits intégrés en trois dimensions à haute densité nécessitent la mise en oeuvre de procédés de gravure anisotrope du silicium afin d'obtenir des vias à profil vertical. La gravure anisotrope du silicium (e.g. U.S. Patent No 5,501,893) conduit le plus souvent à un profil en tonneau (dénommé « bowing » en anglais), rugueux, cannelé ou strié (dénommé « scalloping » en anglais). Ainsi les flancs des vias peuvent être partiellement non recouverts ou recouverts d'une épaisseur insuffisante de couche de germination, provoquant alors un remplissage ultérieur imparfait présentant des défauts de matière (appelés « voids » en anglais). De plus, la couche de germination réalisée sur les flancs des motifs présente par nature une adhérence différente de celle déposée sur la surface plane du substrat. Ceci peut conduire à des performances de fiabilité amoindries. En d'autres termes, le défaut de conformité ne se révèle pas seulement par des différences d'épaisseur ; des défauts de continuité et d'adhérence de la couche sur les flancs des vias peuvent aussi en résulter.

Ces inconvénients rendent très délicat l'emploi de la technologie PVD pour la métallisation des vias traversants de circuits intégrés en trois dimensions à haute densité où les facteurs de forme peuvent être importants.

Dans ce contexte, il existe un besoin important de disposer d'une alternative aux procédés de dépôt chimique ou physique en phase vapeur. Les techniques d'électrodéposition de métaux traditionnellement utilisées ne permettent pas de répondre de façon satisfaisante à ce besoin dans la mesure où elles ne peuvent être mises en oeuvre sur des substrats résistifs et ne conviennent donc pas à la réalisation de couches de germination de cuivre.

A ce jour, l'électrodéposition traditionnelle de cuivre est en effet principalement utilisée pour le remplissage des vias traversants, par application d'un courant à un wafer préalablement couvert d'une couche de germination et plongé dans un bain acide de sulfate de cuivre contenant des additifs (e.g. U.S. Patent No 7,060,624)

Une électrodéposition de cuivre a également été préconisée, notamment par la demande de brevet US2007/0045858A1, pour combler d'éventuels vides dans la couche de germination de structures de type « via traversant » ou pour réparer cette couche ("seed repair" ou "seed enhancement" en anglais).

Dans un mode de réalisation préféré décrit dans ce document antérieur, on réalise dans une première étape une couche de germination en cuivre non uniforme (épaisseur de l'ordre de 200 nanomètres) puis dans une deuxième étape, on améliore la conformité ou l'uniformité de la couche par un procédé de réparation de ladite couche.

On connaît par ailleurs, par le document WO 2007/034116, des compositions d'électrodéposition qui permettent de réaliser des dépôts de couches de germination de cuivre adhérents, conformes et uniformes directement sur des barrières résistives. Si aucune spécification précise ne semble avoir été établie concernant l'épaisseur minimale que doivent avoir les couches de germination de cuivre pour les vias traversants, l'usage est néanmoins de réaliser des dépôts de cuivre de l'ordre de quelques centaines de nanomètres au moins, notamment pour aboutir à une couche de cuivre continue et conforme sur les profils irréguliers dus au scalloping des flancs de vias. Or, les formulations décrites dans le document WO 2007/034116 sont conçues pour la réalisation de dépôts ultra-minces, usuellement d'une épaisseur de moins de 20 nm, sur des substrats ayant des résistivités de l'ordre de quelques dizaines d'ohm/carré. Or il a été constaté que de telles formulations ne permettent pas d'atteindre les épaisseurs plus élevées nécessaires pour les vias traversants, tout au moins avec des temps de dépôt compatibles avec une application industrielle.

On connaît enfin, par le document WO 2007/096390, des compositions d'électrodéposition qui permettent de remplir de cuivre, en une seule et unique étape, des lignes et des trous d'interconnexion dans la fabrication d'éléments semi-conducteurs. Si les formulations décrites dans ce document antérieur permettent la réalisation d'une couche de cuivre relativement épaisse, elles sont conçues spécifiquement pour répondre au problème du remplissage de lignes et de trous d'interconnexion de faible volume dans lequel la question de la conformité du revêtement ne se pose pas. Il a été constaté que les compositions illustrées par les exemples mentionnés dans le document WO 2007/096390 ne sont pas utilisables pour la réalisation de couches de germination de cuivre conformes sur des vias traversants dans la mesure où elles conduisent à des taux de couverture du substrat insuffisants au regard des exigences industrielles actuelles.

Dans ces conditions, la présente invention a pour but de résoudre le nouveau problème technique consistant en la fourniture d'une nouvelle composition destinée à la métallisation des vias traversants, notamment de circuits intégrés en trois dimensions, et permettant de réaliser par électrodéposition des couches de germination en cuivre continues et conformes pour une large gamme de facteurs de forme et présentant une excellente adhésion sur des surfaces de barrière de diffusion pouvant avoir une résistivité élevée.

Il a été découvert, et ceci constitue le fondement de la présente invention, qu'il était possible de résoudre le problème technique précité à l'aide de compositions d'électrodéposition très spécifiques à base d'un mélange de cuivre et d'éthylènediamine précisément choisi.

Ainsi, selon un premier aspect, la présente invention a pour objet une composition d'électrodéposition destinée à revêtir un substrat semi-conducteur servant notamment à fabriquer des structures de type « via traversant » pour la réalisation d'interconnections dans des circuits intégrés, caractérisée en ce qu'elle comprend en solution dans un solvant :
- des ions de cuivre en une concentration comprise entre 14 et 120 mM ;
- de l'éthylènediamine ;
- le rapport molaire entre l'éthylènediamine et le cuivre étant compris entre 1,80 et 2,03 ;
- le pH de ladite composition étant compris entre 6,6 et 7,5.

Par électrodéposition on entend ici un procédé qui permet de recouvrir une surface d'un substrat par un revêtement métallique ou organométallique, dans lequel le substrat est polarisé électriquement et mis au contact d'un liquide contenant des précurseurs dudit revêtement métallique ou organométallique, de manière à former ledit revêtement. Lorsque le substrat est conducteur de l'électricité, l'électrodéposition est par exemple réalisée par passage d'un courant entre le substrat à revêtir constituant une électrode (la cathode dans le cas d'un revêtement métallique ou organométallique) et une seconde électrode (l'anode) dans un bain contenant une source de précurseurs du matériau de revêtement (par exemple des ions métalliques dans le cas d'un revêtement métallique) et éventuellement divers agents destinés à améliorer les propriétés du revêtement formé (régularité et finesse du dépôt, résistivité, etc.), éventuellement en présence d'une électrode de référence.

Par convention, lorsque l'on considère des cellules d'électrolyse, le courant est noté de signe négatif lorsqu'il passe à la cathode du circuit électrochimique (courant cathodique) et il est noté de signe positif lorsqu'il passe à l'anode du circuit électrochimique (courant anodique).

Les compositions d'électrodéposition selon la présente invention peuvent être mises en oeuvre pour toute séquence de réalisation des circuits en trois dimensions (métallisation préalable ou postérieure à l'étape d'amincissement de la tranche de silicium).

Il a été montré que ces compositions permettent d'obtenir de façon tout à fait surprenante, une couche de germination de cuivre conduisant à un taux de couverture du substrat particulièrement élevé (supérieur à 99 %) y compris dans les zones les plus critiques et ce même lorsque la structure présente un facteur de forme élevé (rapport d'aspect supérieur à 3 : 1, voire de l'ordre de 10 à 15 : 1) et un volume de via relativement élevé (de 0,8.10¹ à 5.10⁶ µm³). Ces compositions sont donc parfaitement compatibles avec une utilisation à l'échelle industrielle.

Une famille préférée de compositions comprend celles dont les ions de cuivre sont présents en une concentration comprise entre 16 et 64 mM.

Une autre famille préférée de compositions comprend celles dont le rapport molaire entre les ions de cuivre et l'éthylènediamine est compris entre 1,96 et 2,00.

Bien qu'il n'y ait pas de restriction de principe sur la nature du solvant (pourvu qu'il solubilise suffisamment les espèces actives de la solution et n'interfère pas avec l'électrodéposition), il s'agira de préférence d'eau.

D'une façon générale, la composition d'électrodéposition selon l'invention comprend une source d'ions du cuivre, en particulier d'ions cuivriques Cu²⁺.

Avantageusement, la source d'ions du cuivre est un sel de cuivre tel qu'en particulier le sulfate de cuivre, le chlorure de cuivre, le nitrate de cuivre, l'acétate de cuivre, de préférence le sulfate de cuivre, et de préférence encore le sulfate de cuivre pentahydraté.

Selon une caractéristique particulière, les ions du cuivre sont présents au sein de la composition d'électrodéposition en une concentration comprise entre 14 et 120 mM ; de préférence entre 16 et 64 mM.

D'excellents résultats ont été obtenus avec des compositions dans lesquelles la source d'ions du cuivre est présente en une concentration comprise entre 16 et 32 mM.

Dans la composition d'électrodéposition selon l'invention, le rapport molaire entre les ions du cuivre et l'éthylènediamine est compris entre 1,80 et 2,03, de préférence entre 1,96 et 2,00.

D'une façon générale, la composition d'électrodéposition selon l'invention présente un pH compris entre 6,6 et 7,5. Cette valeur est normalement atteinte lorsque la composition d'électrodéposition selon l'invention est constituée uniquement d'ions du cuivre et d'éthylènediamine dans les proportions mentionnées précédemment.

Le pH de la composition peut éventuellement être ajusté dans la gamme de pH précitée au moyen d'un tampon tel que l'un de ceux décrits dans : « Handbook of chemistry and physics - 84th édition » David R. Lide, CRC Press, dans le cas où la composition d'électrodéposition selon l'invention comporte des composés autres que la source d'ions du cuivre et l'éthylènediamine.

Une composition d'électrodéposition actuellement préférée, selon l'invention, comprend, en solution aqueuse :
- des ions de cuivre, en une concentration comprise entre 16 et 64 mM ;
- de l'éthylènediamine ;
- le rapport molaire entre l'éthylènediamine et les ions de cuivre étant compris entre 1,96 et 2,00 ;
- le pH de ladite composition étant compris entre 6,6 et 7,5.

Les compositions d'électrodéposition selon la présente invention peuvent être mises en oeuvre dans un procédé usuel d'électrodéposition comportant la mise en contact de la surface d'un substrat, tel qu' une couche barrière de diffusion au cuivre d'une structure de type « via traversant », avec une composition d'électrodéposition selon l'invention et une étape de formation d'un revêtement sur ladite surface du substrat au cours de laquelle ladite surface est polarisée pendant une durée suffisante pour former ledit revêtement.

Il a été observé, de façon surprenante, que d'excellents résultats en la matière peuvent être obtenus à l'aide d'une composition d'électrodéposition selon l'invention en contrôlant, lors du procédé d'électrodéposition, les conditions de mise en contact de la surface à revêtir avec ladite composition d'électrodéposition préalablement à la formation du revêtement.

Il a été observé, de façon tout à fait inattendue, qu'il était possible d'obtenir une très bonne adhérence entre la couche de revêtement de cuivre réalisée par électrodéposition et la couche barrière, en mettant la surface à revêtir au contact de la composition d'électrodéposition selon l'invention sans polarisation électrique, c'est-à-dire sans imposer de courant électrique ou de potentiel électrique par rapport à une contre-électrode ou par rapport à une électrode de référence à cette surface, préalablement à l'étape d'électrodéposition.

Une amélioration de cette adhérence a été observée lorsque la surface du substrat à revêtir est maintenue au contact de la composition d'électrodéposition (par exemple par immersion dans la composition d'électrodéposition) pendant une durée d'au moins 1 minute, par exemple de l'ordre de 3 minutes toujours préalablement à l'étape d'électrodéposition.

Cependant, cette amélioration d'adhérence n'est pas observée lorsque le substrat pourvu de sa couche barrière n'est pas revêtu de cuivre dans un bref délai après formation de ladite couche barrière. Ainsi, on a observé une diminution d'adhésion d'environ 50 % entre un substrat recouvert de cuivre par électrodéposition moins d'un jour après formation de la couche barrière et le même substrat revêtu de cuivre par électrodéposition plusieurs jours après formation de la couche barrière.

Dans le cadre de la présente description, on parlera de substrat ayant subi un vieillissement pour désigner un substrat revêtu d'une couche barrière, dont le revêtement par une composition d'électrodéposition selon l'invention est réalisée plusieurs jours après formation de la couche barrière.

Dans ce contexte, il a été observé qu'il était néanmoins possible d'obtenir une très bonne adhérence entre la couche de revêtement de cuivre réalisée par électrodéposition et la couche barrière que celle-ci ait ou non subi un vieillissement, en soumettant ladite couche barrière à un traitement électrochimique de type "polarisation anodique" lorsque celle-ci se trouve au contact de la composition d'électrodéposition selon l'invention, préalablement à l'étape d'électrodéposition.

D'une façon tout à fait surprenante et inattendue, il a été observé que ce traitement par polarisation anodique permet non seulement de corriger intégralement la perte d'adhésion liée au vieillissement de la couche barrière, mais également d'obtenir une adhérence supérieure à celle obtenue en mettant la surface à revêtir au contact de la composition d'électrodéposition selon l'invention sans polarisation électrique, que cette surface ait ou non subi un vieillissement. Ce traitement permet également d'éviter toute perte d'adhérence entre la couche de revêtement de cuivre réalisée par électrodéposition et la couche barrière lorsque celle-ci subit un vieillissement.

D'une façon générale, l'étape de "polarisation anodique" peut être effectuée à une densité de courant d'au moins +0,3 mA.cm⁻², par exemple de l'ordre de +0,9 mA.cm⁻², pendant une durée d'au moins 2 s, par exemple de l'ordre de 30 s.

Il a été constaté que l'amélioration de l'adhérence de la couche de germination sur la couche barrière permet également d'améliorer l'adhésion de l'ensemble « couche de germination / couche de remplissage ou cuivre épais ou couche épaisse », c'est-à-dire l'adhérence « opérationnelle » de l'assemblage pour lequel la couche de germination est réalisée.

On peut par exemple évaluer cette adhésion par pelage (« peeling » en anglais) d'un ruban adhésif collé sur la surface supérieure de l'assemblage par exemple par l'emploi d'une machine d'essai ou de traction. L'adhésion ainsi mesurée, ou énergie d'interface exprimée en J/m², caractérise globalement à la fois l'adhérence de la couche de germination sur la barrière et celle de la couche épaisse de cuivre sur la couche de germination.

Il n'y a pas de restriction de principe sur l'étape de séparation du substrat revêtu de la couche de germination de cuivre après la formation du revêtement.

Il a été observé, qu'il était possible par exemple d'obtenir une couche de germination présentant une conductivité compatible avec les procédés de remplissage par électrodéposition traditionnelle, en maintenant sous polarisation électrique la surface revêtue, de préférence pendant une durée comprise entre 1 et 10 secondes, de préférence pendant une durée comprise entre 1 et 5 secondes après sa séparation de la composition d'électrodéposition.

Ainsi, selon un premier mode de réalisation, les compositions d'électrodéposition selon l'invention seront mises en oeuvre dans un procédé d'électrodéposition comprenant :
- une étape dite d'« entrée à froid » au cours de laquelle ladite surface à revêtir est mise en contact sans polarisation électrique avec un bain d'électrodéposition et de préférence maintenue dans cet état pendant une durée d'au moins 1 minute ;
- une étape de formation du revêtement au cours de laquelle ladite surface est polarisée pendant une durée suffisante pour former ledit revêtement ;
- une étape dite de « sortie à chaud » au cours de laquelle ladite surface est séparée du bain d'électrodéposition tandis qu'elle est encore sous polarisation électrique.

Selon un deuxième mode de réalisation, les compositions d'électrodéposition selon l'invention seront mises en oeuvre dans un procédé d'électrodéposition comprenant :
- une étape au cours de laquelle ladite surface à revêtir est mise en contact et maintenue dans un bain d'électrodéposition sans polarisation électrique pendant une durée très courte inférieure à 5 s, de préférence inférieure à 3 s ;
- une étape de "polarisation anodique" au cours de laquelle ladite surface est polarisée à une densité de courant comprise entre +0,3 mA/cm² et +4 mA/cm², et de préférence comprise entre +0,6 mA/cm² et +1,5 mA/cm² pendant une durée comprise entre 2 s et 3 min, et de préférence entre 20 s et 1 min ;
- une étape au cours de laquelle ladite surface est maintenue dans le bain d'électrodéposition sans polarisation, pendant une durée comprise entre 0 s et 5 min, et de préférence entre 10 s et 1 min ;
- une étape de formation du revêtement au cours de laquelle ladite surface est polarisée pendant une durée suffisante pour former ledit revêtement ;
- une étape dite de « sortie à chaud » au cours de laquelle ladite surface est séparée du bain d'électrodéposition tandis qu'elle est encore sous polarisation électrique.

Ce deuxième mode de réalisation est particulièrement utile dans le cas où le substrat revêtu de la couche barrière a subi un vieillissement important dans le temps préalablement au dépôt de la couche de germination de cuivre.

Dans ce procédé, l'étape de formation du revêtement par électrodéposition est conduite pendant une durée suffisante pour former le revêtement souhaité. Cette durée peut être facilement déterminée par l'homme du métier, la croissance du film étant fonction de la charge qui est égale à l'intégrale temporelle du courant électrique passé dans le circuit pendant le temps du dépôt (loi de Faraday).

D'une façon générale, l'étape d'électrodéposition sera réalisée à température ambiante.

Au cours de l'étape de formation du revêtement, la surface à revêtir peut-être polarisée cathodiquement, soit en mode galvanostatique (courant imposé fixe), soit en mode potentiostatique (potentiel imposé et fixe, éventuellement par rapport à une électrode de référence), soit encore en mode pulsé (en courant ou en tension).

D'une façon générale, il a été observé qu'un revêtement particulièrement satisfaisant peut être obtenu par polarisation en mode pulsé, de préférence de manière à imposer des créneaux de courant.

D'une façon générale, cette étape peut être réalisée en imposant des créneaux de courant correspondants à un courant par unité de surface maximum dans une gamme de -0,6 mA/cm² à -10 mA/cm², et plus particulièrement de -1 mA/cm² à -5 mA/cm² et à un courant par unité de surface minimum dans une gamme de 0 mA/cm² à -5 mA/cm², et de préférence de 0 mA/cm².

Plus particulièrement, la durée de polarisation au courant maximum peut être comprise entre 2.10⁻³ et 1,6 secondes, de préférence entre 0,1 et 0,8 seconde, par exemple de l'ordre de 0,35 seconde, tandis que la durée de polarisation au courant minimum peut être comprise entre 2.10⁻³ et 1,6 secondes, de préférence entre 0,1 et 0,8 seconde, par exemple de l'ordre de 0,25 seconde.

Le nombre de cycles à réaliser au cours de cette étape dépend de l'épaisseur souhaitée du revêtement.

D'une façon générale l'homme du métier déterminera aisément le nombre de cycles à réaliser sachant que dans les conditions préférentielles précitées, et illustrées par les exemples de réalisation, il a été observé que la vitesse de dépôt est d'environ 0,3 nm par seconde.

Ce mode de mise en oeuvre de l'invention a permis de réaliser des couches de germination de cuivre présentant une épaisseur comprise entre 50 nm et 1 µm sur des substrats très résistifs de structures de type « via traversant », dont la résistance carrée peut atteindre 1000 ohm/carré, voire même quelques méga ohm/carré.

Selon un second aspect, la présente invention a pour objet l'utilisation des compositions d'électrodéposition décrites précédemment pour revêtir une couche de barrière de diffusion au cuivre d'une structure de type « via traversant » dans la fabrication d'interconnexions pour des circuits intégrés.

Sous cet aspect, la présente invention couvre également un procédé de revêtement d'une surface d'un substrat, tel qu'en particulier la surface d'une couche barrière de diffusion au cuivre d'une structure de type « via traversant », qui comprend la mise en contact de ladite surface avec une composition d'électrodéposition telle que décrite précédemment et une étape au cours de laquelle ladite surface est polarisée pendant une durée suffisante pour former ledit revêtement.

Selon une caractéristique particulière, la couche barrière de diffusion au cuivre comprend au moins l'un des matériaux choisis parmi le tantale (Ta), le titane (Ti), le nitrure de tantale (TaN), le nitrure de titane (TiN), le tungstène (W), le titanate de tungstène (TiW) et le nitrure ou carbure de tungstène (WCN).

Ce procédé de revêtement est particulièrement utile pour la réalisation d'une couche de germination de cuivre présentant une épaisseur pouvant être de l'ordre de 50 nm à 5 µm, de préférence de 100 nm à 3 µm, par exemple de l'ordre de 300 nm, sur la surface d'une barrière de diffusion au cuivre telle que définie précédemment dans une structure de type « via traversant ».

La présente invention va maintenant être illustrée par les exemples non limitatifs suivants, dans lesquels les compositions selon l'invention sont utilisées pour réaliser le dépôt d'une couche de germination de cuivre sur des vias traversants revêtus d'une couche barrière de diffusion au cuivre. Ces exemples trouvent notamment application dans la fabrication de structures d'interconnexion en cuivre pour circuits intégrés.

### EXEMPLE 1 : Préparation d'une couche de germination de cuivre sur une couche barrière à base de tantale à l'aide d'une composition selon l'invention à base d'un mélange de cuivre et d'éthylènediamine.

### A. Matériel et équipement

### Substrat :

Le substrat utilisé dans cet exemple est constitué d'une plaque de silicium de 200 mm de diamètre et de 750 µm d'épaisseur, gravée avec des motifs cylindriques de type « via traversant » de profondeur 25 µm et de diamètre 5 µm.

Ces motifs sont recouverts d'une couche de silice ayant une épaisseur de 400 nm, elle-même revêtue d'une couche à base de tantale déposée par pulvérisation PVD (Physical Vapor Deposition), et qui se décompose en trois sous couches de tantale (80 nm), nitrure de tantale (15 nm), et à nouveau tantale (10 nm).

Cette « tri-couche » Ta/TaN/Ta constitue une barrière de diffusion au cuivre telle qu'utilisée dans les structures dites « vias traversants » dans la fabrication des circuits intégrés.

Dans cet exemple, le substrat recouvert de la couche barrière de diffusion au cuivre est utilisé très rapidement (par exemple moins de 1 jour) après la formation de la couche barrière.

### Solution d'électrodéposition :

La solution d'électrodéposition mise en oeuvre dans cet exemple est une solution aqueuse contenant 2,1 ml/l (ou 32 mM) d'éthylènediamine et 4 g/l (ou 16 mM) de CuSO₄(H₂O)₅.

Les caractéristiques de la solution sont données dans le Tableau 1.

### Equipement :

Dans cet exemple, on a utilisé un équipement de dépôt électrolytique représentatif de ceux employés dans l'industrie de la microélectronique de marque Semitool^{®} et de type Equinox™ capable de traiter des plaques de 200 mm de diamètre.

Cet équipement comporte une cellule de dépôt électrolytique dans laquelle est réalisé le dépôt de la couche de germination et une station de rinçage/séchage utilisée après dépôt.

La cellule de dépôt électrolytique comporte une anode qui peut être constituée soit en un métal inerte (titane recouvert de platine par exemple), soit en un métal identique à celui constituant la couche de germination, en l'occurrence du cuivre ; la plaque de silicium revêtue par la couche barrière Ta/TaN/Ta, constituant la cathode de cette cellule.

Cette cellule comporte en outre une alimentation électrique stabilisée permettant de fournir jusqu'à 120 V et 15 A et un dispositif de mise en contact électrique de la cathode physiquement isolé de la solution par un joint d'étanchéité. Ce dispositif de mise en contact électrique est généralement de forme annulaire et permet une alimentation du substrat en plusieurs points de contact disposés de manière régulière sur celui-ci.

Elle comporte également un dispositif de support de la plaque à revêtir comportant des moyens de mise en rotation de la dite plaque à vitesse prédéterminée.

### B. Protocole expérimental

Un traitement chimique peut être effectué dans certains cas avant de démarrer le procédé d'électrodéposition. Ce traitement a pour but d'accroître la mouillabilité de la solution d'électrodéposition dans les vias et de chasser les bulles d'air. Il peut consister par exemple à immerger la plaque dans une solution acide ou neutre et à placer le tout dans une cuve à ultrasons pendant une durée d'au moins 5 minutes (par exemple 10 minutes). Ce traitement chimique peut varier suivant la nature de la couche barrière et la dimension des vias traversants.

Le procédé d'électrodéposition mis en oeuvre dans cet exemple comporte les différentes étapes consécutives suivantes.

### Etape 1 : « Entrée à froid »

Cette étape peut être décomposée en deux sous étapes :
1.1. Le substrat précité est introduit dans la cellule de dépôt électrolytique de façon à ce que la face comportant la couche barrière Ta/TaN/Ta vienne au contact du dispositif de mise en contact électrique, ce dernier n'étant toujours pas alimenté électriquement.
1.2. L'ensemble formé par le dispositif de mise en contact électrique et le substrat, qui sera dénommé par la suite « ensemble cathodique » est mis en contact, par exemple par trempage, avec la solution d'électrodéposition. Cette mise en contact, dont la durée est généralement inférieure ou égale à 5 secondes (par exemple 2 secondes) est réalisée alors que le dispositif n'est toujours pas alimenté électriquement. De préférence, l'ensemble cathodique est alors maintenu dans la solution d'électrodéposition sans polarisation pendant une durée d'au moins 1 minute (par exemple de l'ordre de 3 minutes).

### Etape 2 : Formation du revêtement de cuivre

L'ensemble cathodique est alors polarisé en mode galvano-pulsé et simultanément mis en rotation à une vitesse de 20 à 100 tours par minutes (40 tours par minute par exemple).

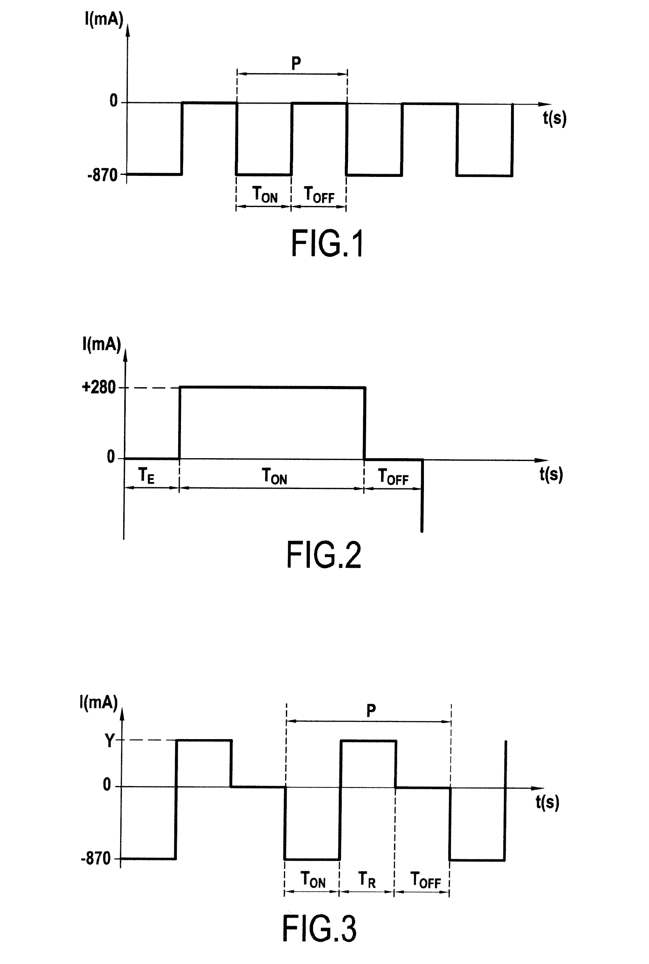

La Figure 1 décrit en détail le protocole galvano-pulsé susceptible d'être utilisé, avec une période totale P comprise entre 10 ms et 2 s (0,6 s dans l'exemple), un temps de polarisation T_{ON} compris entre 2 ms et 1,6 s (0,35 s dans l'exemple) en imposant un courant par unité de surface généralement compris entre -0,6 mA/cm² et -10 mA/cm² (-2,77 mA/cm² dans l'exemple), un temps de repos sans polarisation compris entre 2 ms et 1,6 s (0,25 s dans l'exemple).

La durée de cette étape dépend, comme on le comprend, de l'épaisseur souhaitée de la couche de germination. Cette durée peut être facilement déterminée par l'homme du métier, la croissance du film étant fonction de la charge passée dans le circuit.

Dans les conditions précitées, la vitesse de dépôt est d'environ 1,5 nm par coulomb de charge passée dans le circuit, ce qui donne une durée de l'étape d'électrodéposition de l'ordre de 17 minutes pour obtenir un revêtement ayant une épaisseur de 300 nm.

### Etape 3 : « Sortie à chaud »

Cette étape peut être décomposée en deux sous étapes :
3.1. Après l'étape d'électrodéposition, l'ensemble cathodique revêtu de cuivre est retiré de la solution d'électrodéposition à vitesse de rotation nulle en étant maintenu sous polarisation en tension. La durée de cette phase est d'environ 2 secondes.

La vitesse de rotation est alors portée à 500 tours par minute pendant 10 secondes, la polarisation de l'ensemble cathodique étant coupée pendant cette dernière phase.

Un pré-rinçage à l'eau dé-ionisée est effectué dans la cellule.
3.2. Le substrat revêtu de la couche de germination est alors transféré dans le module de rinçage/séchage pour subir un rinçage à l'eau dé-ionisée.

L'eau de rinçage est alors évacuée puis un séchage sous balayage d'azote est réalisé.

La rotation est alors stoppée pour permettre le retrait du substrat revêtu et séché.

Dans cet exemple, l'étape de sortie et en particulier le retrait de l'ensemble cathodique de la solution d'électrodéposition a été effectué sous polarisation en tension au même niveau que durant l'étape de formation du dépôt.

### C. Résultats obtenus

En appliquant le protocole expérimental exposé ci-dessus, une couche de cuivre de 300 nm d'épaisseur a été obtenue.

Les mesures et caractérisations effectuées sur cette couche (300 nm) sont présentées dans les exemples 18 à 20.

### EXEMPLE 2 : Préparation d'une couche de germination de cuivre sur une couche barrière à base de tantale à l'aide d'une composition selon l'invention à base d'un mélange de cuivre et d'éthylènediamine.

En appliquant le protocole expérimental exposé à l'exemple 1, une couche de germination de cuivre de 300 nm d'épaisseur a été préparée, à l'aide des solutions d'électrodéposition selon l'invention dont les caractéristiques sont données dans le Tableau 1.

Les mesures et caractérisations effectuées sur cette couche (300 nm) sont présentées dans les exemples 18 à 20.

### EXEMPLE 3 : Préparation d'une couche de germination de cuivre sur une couche barrière à base de tantale à l'aide d'une composition selon l'invention à base d'un mélange de cuivre et d'éthylènediamine

### A. Matériel et équipement

### Substrat :

Le substrat utilisé dans cet exemple est identique au substrat utilisé à l'exemple 1.

### Solution d'électrodéposition :

La solution d'électrodéposition mise en oeuvre dans cet exemple est une solution aqueuse contenant 8,4 ml/l (ou 128 mM) d'éthylènediamine et 16 g/l (ou 64 mM) de CuSO₄ (H₂O)₅, présentant un pH de 7,2.

### Equipement :

L'équipement utilisé dans cet exemple est identique à celui de l'exemple 1.

### B. Protocole expérimental

Quatre séries d'expérimentations ont été utilisées.

### B.1. Entrée à froid sans vieillissement de la couche barrière

Le protocole expérimental utilisé ici est strictement identique à celui de l'exemple 1, la formation de la couche de germination de cuivre étant réalisée rapidement (moins de 1 jour) après formation de la couche barrière.

### B.2. Entrée à froid après vieillissement de la couche barrière

Le protocole expérimental utilisé ici est identique à celui de l'exemple 1 si ce n'est que la formation de la couche de germination de cuivre est réalisée plusieurs jours après la formation de la couche barrière.

### B.3. Polarisation anodique après vieillissement de la couche barrière

On a utilisé ici un substrat revêtu d'une couche barrière ayant subi le même vieillissement que le substrat utilisé dans le protocole B.2. précité.

Le procédé d'électrodéposition mis en oeuvre pour la formation de la couche de germination du cuivre comporte une mise en contact de la couche à revêtir sous polarisation anodique.

Ce procédé d'électrodéposition comporte les différentes étapes consécutives suivantes.

### Etape 1 : Entrée sous polarisation anodique

La Figure 2 illustre le protocole d'entrée sous polarisation anodique susceptible d'être utilisé, ce protocole pouvant être décomposée en trois sous étapes :
1.1. Le substrat précité est introduit dans la cellule de dépôt électrolytique de façon à ce que la face comportant la couche barrière à base de tantale vienne au contact du dispositif de mise en contact électrique, ce dernier n'étant toujours pas alimenté électriquement.
1.2. L'ensemble formé par le dispositif de mise en contact électrique et le substrat, qui sera dénommé par la suite « ensemble cathodique » est mis en contact, par exemple par trempage, avec la solution d'électrodéposition. Cette mise en contact, dont la durée est généralement inférieure ou égale à 5 secondes (par exemple 2 secondes) est réalisée alors que le dispositif n'est toujours pas alimenté électriquement. De préférence, l'ensemble cathodique est alors maintenu dans la solution d'électrodéposition sans polarisation pendant une durée T_{E} inférieure ou égale à 5 secondes (par exemple 3 secondes).
1.3. L'ensemble cathodique est alors polarisé anodiquement en imposant un courant par unité de surface généralement compris entre +0,3 mA/cm² et +4 mA/cm² (+0,9 mA/cm² dans l'exemple), pendant une durée T_{ON} comprise entre 2 secondes et 3 minutes (30 s dans l'exemple).
1.4. La polarisation anodique est alors coupée, l'ensemble cathodique étant toujours maintenu dans la solution d'électrodéposition pendant une durée T_{OFF} comprise entre 0 seconde et 5 minutes (1 minute dans l'exemple).

### Etape 2 : Formation du revêtement de cuivre

Cette étape est identique à l'étape correspondante de l'exemple 1.

### Etape 3 : « Sortie à chaud »

Cette étape est identique à l'étape correspondante de l'exemple 1.

### B.4. Polarisation anodique sans vieillissement de la couche barrière

Le protocole expérimental qui a été utilisé est strictement identique au protocole B.3. décrit ci-dessus, si ce n'est qu'il a été appliqué au même substrat sans que celui-ci n'ait subi un quelconque vieillissement.

### C. Résultats obtenus

En appliquant le protocole expérimental exposé ci-dessus, une couche de cuivre de 300 nm d'épaisseur a été obtenue.
Les mesures et caractérisations effectuées après dépôt de la couche de germination (300 nm) sont présentées dans les exemples 18 à 20.

### EXEMPLE 4: Préparation d'une couche de germination de cuivre sur des structures de type « vias traversants » recouverts d'une couche barrière de nitrure de titane à l'aide d'une composition selon l'invention à base d'un mélange de cuivre et d'éthylènediamine.

### A. Matériel et équipement

### Substrat :

Le substrat utilisé dans cet exemple est constitué d'une plaque de silicium de 200 mm de diamètre et de 750 µm d'épaisseur, gravée avec des motifs cylindriques de type « via traversant » de profondeur 50 µm et de diamètre 5 µm.

Ces motifs sont recouverts d'une couche de silice ayant une épaisseur de 400 nm, elle-même revêtue d'une couche de nitrure de titane TiN de 40 nm déposée par CVD (Chemical Vapor Deposition).

Le nitrure de titane constitue une barrière de diffusion au cuivre telle qu'utilisée dans les structures dites « vias traversants » dans la fabrication des circuits intégrés.

### Solution d'électrodéposition :

La solution d'électrodéposition mise en oeuvre dans cet exemple est identique à celle de l'exemple 3.

### Equipement :

L'équipement mis en oeuvre dans cet exemple est identique à celui de l'exemple 1.

### B. Protocole expérimental

Quatre séries d'expérimentations ont été réalisées en suivant les protocoles B.1., B.2., B.3. et B.4. décrits à l'exemple 3.

Dans chaque cas, une couche de cuivre de 300 nm d'épaisseur a été obtenue.

### C. Résultats obtenus

Les mesures et caractéristiques effectuées sur cette couche sont présentées dans les exemples 18 à 20.

### EXEMPLE 5 : Préparation d'une couche de germination de cuivre sur une couche barrière de nitrure de titane à l'aide d'une composition selon l'invention à base d'un mélange de cuivre et d'éthylènediamine.

### A. Matériel et équipement

### Substrat :

Le substrat utilisé dans cet exemple est constitué d'une plaque de silicium de 200 mm de diamètre et de 750 µm d'épaisseur, gravée avec des motifs cylindriques de type « via traversant » de profondeur 200 µm et de diamètre 75 µm.

Ces motifs sont recouverts d'une couche de silice ayant une épaisseur de 400 nm, elle-même revêtue d'une couche de nitrure de titane de 50 nm déposée par ALD (Atomic Layer Deposition).

Le nitrure de titane constitue une barrière de diffusion au cuivre telle qu'utilisée dans les structures dites « vias traversants » dans la fabrication des circuits intégrés.

### Solution d'électrodéposition :

La solution utilisée dans cet exemple est identique à celle de l'exemple 1.

### Equipement :

L'équipement utilisé dans cet exemple est identique à celui de l'exemple 1.

### B. Protocole expérimental

Le protocole expérimental utilisé dans cet exemple est identique à celui de l'exemple 1.

### C. Résultats obtenus

En appliquant le protocole expérimental exposé ci-dessus, une couche de cuivre de 300 nm d'épaisseur a été obtenue.

Les mesures et caractérisations effectuées après dépôt de la couche de germination (300 nm) sont présentées dans les exemples 18 à 20.

### EXEMPLE 6 : Préparation d'une couche de germination de cuivre sur une couche barrière de nitrure de titane à l'aide d'une composition selon l'invention à base d'un mélange de cuivre et d'éthylènediamine.

### A. Matériel et équipement

### Substrat :

Le substrat utilisé dans cet exemple est constitué d'une plaque de silicium de 200 mm de diamètre et de 750 µm d'épaisseur, gravée avec des motifs cylindriques de type « via traversant » de profondeur 50 µm et de diamètre 5 µm.

Ces motifs sont recouverts d'une couche de silice ayant une épaisseur de 400 nm, elle-même revêtue d'une couche de nitrure de titane de 40 nm déposée par CVD (Chemical Vapor Deposition).

Le nitrure de titane constitue une barrière de diffusion au cuivre telle qu'utilisée dans les structures dites « vias traversants » dans la fabrication des circuits intégrés.

### Solution d'électrodéposition :

La solution utilisée dans cet exemple est identique à celle de l'exemple 1.

### Equipement :

L'équipement utilisé dans cet exemple est identique à celui de l'exemple 1.

### B. Protocole expérimental

Le protocole expérimental utilisé dans cet exemple est identique à celui de l'exemple 1.

### C. Résultats obtenus

En appliquant le protocole expérimental exposé ci-dessus, une couche de cuivre de 300 nm d'épaisseur a été obtenue.

Les mesures et caractérisations effectuées après dépôt de la couche de germination (300 nm) sont présentées dans les exemples 18 à 20.

### EXEMPLE 7 : Préparation d'une couche de germination de cuivre sur des structures de type « vias traversants » recouverts d'une couche barrière de nitrure de titane à l'aide d'une composition selon l'invention à base d'un mélange de cuivre et d'éthylènediamine.

### A. Matériel et équipement

### Substrat :

Le substrat utilisé dans cet exemple est identique au substrat utilisé à l'exemple 1.

### Solution d'électrodéposition :

La solution d'électrodéposition utilisée dans cet exemple est identique à celle de l'exemple 3.

### Equipement :

L'équipement utilisé dans cet exemple est identique à celui de l'exemple 1.

### B. Protocole expérimental

Dans cet exemple, on a utilisé un protocole dit de "pulse reverse" pour réaliser le revêtement de germination de cuivre. La formation de la couche de germination de cuivre est réalisée plusieurs jours après la formation de la couche barrière.

Le procédé d'électrodéposition mis en oeuvre dans cet exemple comporte les différentes étapes consécutives suivantes.

### Etape 1 : Entrée sous polarisation anodique

Le protocole expérimental utilisé est identique au protocole B.3. décrit à l'exemple 3.

### Etape 2 : Formation du revêtement de cuivre

L'ensemble cathodique est alors polarisé en mode « pulse reverse » et simultanément mis en rotation à une vitesse de 20 à 100 tours par minutes (40 tours par minute dans l'exemple).

La Figure 3 illustre le protocole dit « pulse reverse » susceptible d'être utilisé, avec une période totale P comprise entre 10 ms et 3 s (0,9 s dans l'exemple), un temps de polarisation cathodique T_{ON} compris entre 2 ms et 1,6 s (0,35 s dans l'exemple) en imposant un courant par unité de surface généralement compris entre -0,6 mA/cm² et -10 mA/cm² (-2,77 mA/cm² dans l'exemple), un temps de polarisation anodique T_{R} compris entre 2 ms et 1,6 s (0,25 s dans l'exemple) en imposant un courant par unité de surface généralement compris entre +0,2 mA/cm² et +5 mA/cm² (+1,11 mA/cm² dans l'exemple) et un temps de repos éventuel sans polarisation T_{OFF} compris entre 0 s et 1 s (0,3 s dans l'exemple).

La durée de cette étape dépend, comme on le comprend, de l'épaisseur souhaitée de la couche de germination. Cette durée peut être facilement déterminée par l'homme du métier, la croissance du film étant fonction de la charge passée dans le circuit.

### Etape 3 : « Sortie à chaud »

Cette étape est identique à l'étape correspondante de l'exemple 1.

Le même protocole expérimental a été appliqué au même substrat n'ayant subi aucun vieillissement.

### C. Résultats obtenus

En appliquant le protocole expérimental exposé ci-dessus, une couche de cuivre de 300 nm d'épaisseur a été obtenue.

Les mesures et caractérisations effectuées après dépôt de la couche de germination (300 nm) sont présentées dans les exemples 18 à 20.

### EXEMPLE 8 : Préparation d'une couche de germination de cuivre sur des structures de type « vias traversants » recouverts d'une couche barrière de titane à l'aide d'une composition selon l'invention à base d'un mélange de cuivre et d'éthylènediamine.

### A. Matériel et équipement

### Substrat :

Le substrat utilisé dans cet exemple est constitué d'une plaque de silicium de 200 mm de diamètre et de 750 µm d'épaisseur, gravée avec des motifs cylindriques de type « via traversant » de profondeur 60 µm et de diamètre 30 µm.

Ces motifs sont recouverts d'une couche de silice ayant une épaisseur de 400 nm, elle-même revêtue d'une couche de titane Ti de 0,3 µm déposée par pulvérisation PVD (Physical Vapor Deposition).

Le titane constitue une barrière de diffusion au cuivre telle qu'utilisée dans les structures dites « vias traversants » dans la fabrication des circuits intégrés.

### Solution d'électrodéposition :

La solution d'électrodéposition mise en oeuvre dans cet exemple est identique à celle de l'exemple 3.

### Equipement :

L'équipement mis en oeuvre dans cet exemple est identique à celui de l'exemple 1.

### B. Protocole expérimental

Quatre séries d'expérimentations ont été réalisées en suivant les protocoles B.1., B.2., B.3. et B.4. décrits à l'exemple 3.

Dans chaque cas, une couche de cuivre de 300 nm d'épaisseur a été obtenue.

### C. Résultats obtenus

Les mesures et caractéristiques effectuées sur cette couche sont présentées dans les exemples 18 à 20.

### EXEMPLE 9 : Préparation d'une couche de germination de cuivre sur une couche barrière de titane à l'aide d'une composition selon l'invention à base d'un mélange de cuivre et d'éthylènediamine.

### A. Matériel et équipement

### Substrat :

Le substrat utilisé dans cet exemple est constitué d'une plaque de silicium de 200 mm de diamètre et de 750 µm d'épaisseur, gravée avec des motifs cylindriques de type « via traversant » de profondeur 60 µm et de diamètre 30 µm.

Ces motifs sont recouverts d'une couche de silice ayant une épaisseur de 400 nm, elle-même revêtue d'une couche de titane de 0,3 µm déposée par pulvérisation PVD (Physical Vapor Deposition).

Le titane constitue une barrière de diffusion au cuivre telle qu'utilisée dans les structures dites « vias traversants » dans la fabrication des circuits intégrés.

### Solution d'électrodéposition :

La solution utilisée dans cet exemple est identique à celle de l'exemple 1.

### Equipement :

L'équipement utilisé dans cet exemple est identique à celui de l'exemple 1.

### B. Protocole expérimental

Le protocole expérimental utilisé dans cet exemple est identique à celui de l'exemple 1.

### C. Résultats obtenus

En appliquant le protocole expérimental exposé ci-dessus, une couche de cuivre de 300 nm d'épaisseur a été obtenue.

Les mesures et caractérisations effectuées après dépôt de la couche de germination (300 nm) sont présentées dans les exemples 18 à 20.

### EXEMPLES COMPARATIFS 10 à 17: Préparation d'une couche de germination de cuivre sur une couche barrière à base de tantale à l'aide d'une composition de référence à base d'un mélange de cuivre et d'éthylènediamine.

En appliquant le protocole expérimental exposé à l'exemple 1, une couche de germination de cuivre de 300 nm d'épaisseur a été préparée, à l'aide des solutions d'électrodéposition de référence dont les caractéristiques sont données dans le Tableau 1.

Les mesures et caractérisations effectuées sur cette couche (300 nm) sont présentées dans les exemples 18 à 20.

**TABLEAU 1**

| Les caractéristiques des solutions préparées dans les exemples 1 à 17 qui précèdent sont résumées dans le tableau suivant. | | | |
|---|---|---|---|
| **Solution d'électrodéposition préparée selon** | **Cuivre (mM)** | **Ethylènediamine (mM)** | **pH** |
| Exemple 1 | 16 | 32 | 7.2 |
| Exemple 2 | 40 | 80 | 7.2 |
| Exemple 3 | 64 | 128 | 7.2 |
| Exemple 4 | 64 | 128 | 7.2 |
| Exemple 5 | 16 | 32 | 7.2 |
| Exemple 6 | 16 | 32 | 7.2 |
| Exemple 7 | 64 | 128 | 7.2 |
| Exemple 8 | 64 | 128 | 7.2 |
| Exemple 9 | 16 | 32 | 7.2 |
| Exemple comparatif 10 | 128 | 256 | 7.2 |
| Exemple comparatif 11 | 12 | 24 | 7.2 |
| Exemple comparatif 12 | 8 | 16 | 7.2 |
| Exemple comparatif 13 | 4 | 8 | 7.2 |
| Exemple comparatif 14 | 16 | 23.8 | 6.3 |
| Exemple comparatif 15 | 16 | 35.2 | 10.6 |
| Exemple comparatif 16 | 16 | 40 | 11 |
| Exemple comparatif 17 | 16 | 46.2 | 11.1 |

### EXEMPLE 18: Caractérisation de la résistivité de la couche de germination obtenue dans des structures de type « via traversant » à l'aide des compositions selon l'invention et des compositions de référence à base d'un mélange de cuivre et d'éthylènediamine.

### A. Matériel et éguipement

La résistance carrée (dénommée « sheet résistance » en anglais) a été mesurée à l'aide d'un appareil de type mesure « 4 pointes » (dénommé « four point probe » en anglais) bien connu de l'homme du métier pour la mesure de la résistance électrique des couches minces. Elle est exprimée en ohm/carré et elle est équivalente à la résistivité pour un système bidimensionnel, c'est-à-dire dans lequel le courant circule dans le plan de la couche et non dans un plan perpendiculaire à cette couche. Mathématiquement, on obtient la valeur de la résistance carrée en divisant la résistivité du matériau (exprimée en ohm.m ou micro-ohm.cm) constitutif de la couche par l'épaisseur de cette couche (exprimée en m ou nm).

### B. Méthode de mesure

La valeur de résistance carrée multipliée par l'épaisseur de la couche de germination donne la résistivité du cuivre.

### C. Résultats obtenus

Les résistivités du cuivre obtenues aux exemples 1 à 14 qui précèdent sont de l'ordre de 2 µohm.cm pour une couche de germination de 200 nm et 1.8 µohm.cm pour une couche de germination de 400 nm et plus.

Ces niveaux de résistivité sont tout à fait compatibles avec une utilisation à l'échelle industrielle.

### EXEMPLE 19: Caractérisation de la couverture de la couche de germination obtenue dans des structures de type « via traversant » à l'aide des compositions selon l'invention et des compositions de référence à base d'un mélange de cuivre et d'éthylènediamine.

### A. Matériel et équipement

La couverture et la conformité de la couche de germination en cuivre ont été évaluées à partir d'observations en coupe au microscope électronique à balayage, en focalisant sur le bas des structures qui constitue la zone la plus difficile à couvrir.

### B. Méthode de mesure

Le pourcentage de couverture est mesuré dans la zone basse des structures, entre le fond des vias et 4 µm au dessus. Un pourcentage de 100 % correspond à une couverture complète i.e. dans la zone basse la surface de la barrière est entièrement recouverte de cuivre. Une surface partiellement recouverte de cuivre est caractérisée par la fraction de la surface recouverte de cuivre, exprimée en pourcent.

Lorsque la couverture est complète, le pourcentage de conformité est calculé en rapportant l'épaisseur de la couche de germination sur les surfaces verticales (profil ou flanc) du via à celle sur les surfaces horizontales en haut du via. L'épaisseur sur les surfaces verticales est mesurée à une profondeur du via donnée (4 µm au dessus du fond du via). Un pourcentage de 100 % correspond à une conformité parfaite.

### C. Résultats obtenus

Le Tableau 2 ci-dessous rassemble les résultats obtenus sur les couches de germination de cuivre préparées à l'aide des compositions des exemples 1 à 17 qui précèdent.

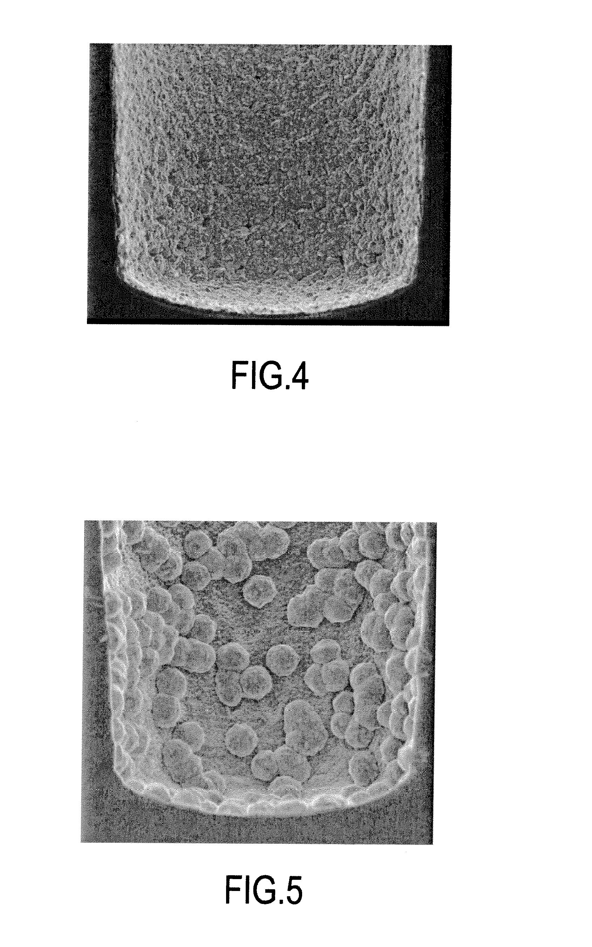

Les observations au microscope électronique à balayage (grossissement 20 K) sont reportées sur la Figure 4 dans le cas de l'exemple 1 (couverture 100 %), et sur la Figure 5 dans le cas de l'exemple comparatif 11 (couverture 55 %).

**Tableau 2 : conformité et couverture des couches de germination en cuivre obtenues selon les exemples 1 à 17.**

| **Couche de germination en cuivre obtenue selon** | **Couverture (%)** | **Conformité (%)** |
|---|---|---|
| Exemple 1 | 100 | 80-100 |
| Exemple 2 | 100 | 70-90 |
| Exemple 3 (protocole B1) | 100 | 70-90 |
| Exemple 3 (protocole B3) | 100 | 80-100 |
| Exemple 4 (protocole B3) | 100 | 40-60 |
| Exemple 5 | 100 | 30-40 |
| Exemple 6 | 100 | 30-50 |
| Exemple 7 | 100 | 80-100 |
| Exemple 8 (protocole B3) | 100 | 50-70 |
| Exemple 9 | 100 | 40-60 |
| Exemple comparatif 10 | 45 | - |
| Exemple comparatif 11 | 90 | - |
| Exemple comparatif 12 | 85 | - |
| Exemple comparatif 13 | 60 | - |
| Exemple comparatif 14 | 95 | - |
| Exemple comparatif 15 | 90 | - |
| Exemple comparatif 16 | 75 | - |
| Exemple comparatif 17 | 55 | - |

Les résultats regroupés dans le Tableau 2 qui précède montrent le caractère critique de la composition d'électrodéposition selon l'invention.

Toutes les compositions d'électrodéposition conformes à la présente invention (exemples 1 à 9) conduisent à un taux de couverture du substrat de 100 % et à une conformité d'au moins 30 % satisfaisante à l'échelle industrielle. La composition de l'exemple 1 conduit à un taux de conformité excellent pouvant atteindre 100 %.

Des compositions de référence (exemples 10 à 17) relativement proches (d'un point de vue qualitatif et quantitatif) des compositions revendiquées conduisent à des taux de couverture inférieurs à 95 %, ce qui les rend inutilisables en pratique à l'échelle industrielle.

### EXEMPLE 20: Caractérisation de l'adhésion de la couche de germination obtenue dans des structures de type « via traversant » à l'aide des compositions selon l'invention et des compositions de référence à base d'un mélange de cuivre et d'éthylènediamine.

### A. Matériel et équipement

L'adhésion ou énergie d'interface a été mesurée à l'aide d'un dispositif (dit machine d'essai ou de traction) qui exerce une force de tension verticale croissante sur la surface par l'intermédiaire d'un ruban adhésif puissant jusqu'à ce que la couche de cuivre se sépare du substrat.

### B. Méthode de mesure

Le travail de la force (force multipliée par longueur de la couche qui a délaminé), mesuré grâce à l'appareillage décrit précédemment, équivaut à l'énergie qu'il a fallu fournir pour séparer la couche de cuivre de son substrat. En divisant cette énergie par la valeur de la surface qui a délaminé, on obtient l'énergie par unité de surface.

### C. Résultats obtenus

Le Tableau 3 ci-dessous rassemble les résultats obtenus aux exemples 1 à 17 qui précèdent.

**Tableau 3 : adhésion des couches de germination en cuivre obtenues selon les exemples 1 à 17.**

| Couche de germination en cuivre obtenue selon | Entrée à froid | | Polarisation anodique | |
|---|---|---|---|---|
| | sans vieillissement | après vieillissement | après vieillissement | sans vieillissement |
| Exemple 1 | 8 | | | |
| Exemple 2 | 5 | | | |
| Exemple 3 | 5 | 1,5 | 9 | 9 |
| Exemple 4 | 6 | 2,5 | 10 | 10 |
| Exemple 5 | 7 | | | |
| Exemple 6 | 10 | | | |
| Exemple 7 | | | 11 | 11 |
| Exemple 8 | 5 | 2,5 | 11 | 11 |
| Exemple 9 | 8 | | | |
| Ex. comparatif 10 | 3 | | | |
| Ex. comparatif 11 | 8 | | | |
| Ex. comparatif 12 | 7 | | | |
| Ex. comparatif 13 | 8 | | | |
| Ex. comparatif 14 | 7 | | | |
| Ex. comparatif 15 | 6 | | | |
| Ex. comparatif 16 | 5 | | | |
| Ex. comparatif 17 | 4 | | | |

Les résultats regroupés dans le Tableau 3 ci-dessus montrent que les compositions conformes à la présente invention conduisent à des couches de germination de cuivre présentant une bonne adhésion compatible avec une application industrielle.

Ce tableau montre également l'intérêt, d'un point de vue industriel, du protocole de polarisation anodique qui sera avantageusement utilisé dans tous les cas où le substrat pourvu de sa couche barrière a subi un vieillissement dans le temps.

## Revendications

1. Composition d'électrodéposition destinée à revêtir un substrat semi-conducteur servant à fabriquer des structures de type « via traversant », notamment pour la réalisation d'interconnections dans des circuits intégrés, **caractérisée en ce qu'**elle comprend, en solution dans un solvant :
- des ions de cuivre en une concentration comprise entre 14 et 120 mM ;
- de l'éthylènediamine ;
- le rapport molaire entre l'éthylènediamine et le cuivre étant compris entre 1,80 et 2,03 ;
- le pH de ladite composition étant compris entre 6,6 et 7,5.

2. Composition selon la revendication 1, **caractérisée en ce que** la concentration d'ions de cuivre est comprise entre 16 et 64 mM.

3. Composition selon la revendication 1 ou 2, **caractérisée en ce que** les ions de cuivre précités sont des ions cuivriques provenant de préférence de sulfate de cuivre.

4. Composition selon l'une des revendications 1 à 3, **caractérisée en ce que** le rapport molaire entre l'éthylènediamine et les ions du cuivre est compris entre 1,96 et 2,00.

5. Composition selon l'une des revendications 1 à 4, **caractérisée en ce qu'**elle permet d'obtenir un revêtement de substrat avec un taux de couverture supérieur à 99 %.

6. Composition selon l'une des revendications 1 à 5, **caractérisée en ce qu'**elle permet d'obtenir un revêtement de substrat présentant une conformité supérieure à 30%.

7. Utilisation de la composition selon l'une des revendications 1 à 6, pour le dépôt de la couche de germination de cuivre présentant un taux de couverture supérieur à 99 % et une conformité supérieure à 30% sur un substrat semi-conducteur d'une structure de type « via traversant » pour la réalisation d'interconnections dans des circuits intégrés.

8. Procédé de revêtement d'une surface d'une couche barrière de diffusion au cuivre d'une structure de type « via traversant », notamment pour la réalisation d'interconnections dans des circuits intégrés, qui comprend la mise en contact de ladite surface avec une composition d'électrodéposition selon l'une des revendications 1 à 6, et une étape au cours de laquelle ladite surface est polarisée pendant une durée suffisante pour former ledit revêtement.

9. Procédé de revêtement selon la revendication 8, **caractérisé en ce que** la surface formant barrière de diffusion au cuivre comprend au moins l'un des matériaux choisis parmi le tantale (Ta), le titane (Ti), le nitrure de tantale (TaN), le nitrure de titane (TiN), le tungstène (W), le titanate de tungstène (TiW) et le nitrure ou carbure de tungstène (WCN).

10. Procédé de revêtement selon la revendication 9, **caractérisé en ce que** la surface formant barrière de diffusion au cuivre est constituée d'une tri-couche tantale/nitrure de tantale/tantale ou d'une bicouche nitrure de tantale/tantale ou d'une couche de nitrure de titane.

## Patentansprüche

1. Elektroplattierungszusammensetzung zur Beschichtung eines Halbleitersubstrats, das zur Herstellung von Strukturen vom Typ "durchgehende Via" dient, insbesondere für die Herstellung von Verbindungen in integrierten Schaltkreisen, **dadurch gekennzeichnet, dass** sie in Lösung in einem Lösungsmittel umfasst:
- Kupferionen in einer Konzentration zwischen 14 und 120 mM,
- Ethylendiamin,
- wobei das Molverhältnis zwischen dem Ethylendiamin und dem Kupfer zwischen 1,80 und 2,03 beträgt,
- wobei der pH-Wert der Zusammensetzung im Bereich zwischen 6,6 und 7,5 liegt.

2. Zusammensetzung nach Anspruch 1, **dadurch gekennzeichnet, dass** die Kupferionenkonzentration zwischen 16 und 64 mM beträgt.

3. Zusammensetzung nach Anspruch 1 oder 2, **dadurch gekennzeichnet, dass** die vorgenannten Kupferionen vorzugsweise aus Kupfersulfat stammende Kupfer(II)-Ionen sind.

4. Zusammensetzung nach einem der Ansprüche 1 bis 3, **dadurch gekennzeichnet, dass** das Molverhältnis zwischen dem Ethylendiamin und den Ionen des Kupfers zwischen 1,96 und 2,00 beträgt.

5. Zusammensetzung nach einem der Ansprüche 1 bis 4, **dadurch gekennzeichnet, dass** sie ermöglicht, eine Substratbeschichtung mit einem Abdeckungsgrad von über 99 % zu erhalten.

6. Zusammensetzung nach einem der Ansprüche 1 bis 5, **dadurch gekennzeichnet, dass** sie ermöglicht, eine Substratbeschichtung mit einer Konformität von über 30 % zu erhalten.

7. Verwendung der Zusammensetzung nach einem der Ansprüche 1 bis 6, für die Abscheidung der Kupferkeimschicht, die einen Abdeckungsgrad von über 99 % und eine Konformität von über 30 % aufweist, auf einem Halbleitersubstrat mit einer Struktur vom Typ "durchgehende Via" für die Herstellung von Verbindungen in integrierten Schaltkreisen.

8. Verfahren zur Beschichtung einer Oberfläche einer Kupferdiffusionssperrschicht einer Struktur vom Typ "durchgehende Via", insbesondere für die Herstellung von Verbindungen in integrierten Schaltkreisen, das das Inkontaktbringen der Oberfläche mit einer Elektroplattierungszusammensetzung nach einem der Ansprüche 1 bis 6 sowie einen Schritt umfasst, im Laufe dessen die Oberfläche für eine zur Bildung der Beschichtung ausreichende Zeitdauer polarisiert wird.

9. Beschichtungsverfahren nach Anspruch 8, **dadurch gekennzeichnet, dass** die eine Kupferdiffusionssperre bildende Oberfläche wenigstens eines der Materialien, ausgewählt aus Tantal (Ta), Titan (Ti), Tantalnitrid (TaN), Titannitrid (TiN), Wolfram (W), Wolframtitanat (TiW) und Wolframnitrid oder -karbid (WCN), umfasst.

10. Beschichtungsverfahren nach Anspruch 9, **dadurch gekennzeichnet, dass** die eine Kupferdiffusionssperre bildende Oberfläche von einer Dreifachschicht Tantal/Tantalnitrid/Tantal oder von einer Zweifachschicht Tantalnitrid/Tantal oder von einer Schicht aus Titannitrid gebildet ist.

## Claims

1. Electrodeposition composition intended for coating a semiconductor substrate in order to fabricate structures of the "through via" type, particularly for the production of interconnects in integrated circuits, **characterized in that** it comprises, in solution in a solvent:
- copper ions in a concentration of between 14 and 120 mM;
- ethylenediamine;
- the molar ratio between ethylenediamine and copper being between 1.80 and 2.03;
- the pH of the said composition being between 6.6 and 7.5.

2. Composition according to Claim 1, **characterized in that** the concentration of copper ions is between 16 and 64 mM.

3. Composition according to Claim 1 or 2, **characterized in that** aforementioned copper ions are cupric ions preferably originating from copper sulfate.

4. Composition according to one of Claims 1 to 3, **characterized in that** the molar ratio between ethylenediamine and copper ions is between 1.96 and 2.00.

5. Composition according to one of Claims 1 to 4, **characterized in that** it makes it possible to obtain a substrate coating having a coverage factor of more than 99%.

6. Composition according to one of Claims 1 to 5, **characterized in that** it makes it possible to obtain a substrate coating having a conformity of more than 30%.

7. Use of the composition according to one of Claims 1 to 6, for deposition of the copper seed layer having a coverage factor of more than 99% and a conformity of more than 30% on a semiconductor substrate of a structure of the "through via" type for the production of interconnects in integrated circuits.

8. Method for coating a surface of a barrier layer against copper diffusion of a structure of the "through via" type particularly for the production of interconnects in integrated circuits, which comprises bringing the said surface in contact with an electrodeposition composition according to one of Claims 1 to 6 and a step during which the said surface is polarized for a sufficient time to form the said coating.

9. Coating method according to Claim 8, **characterized in that** the surface forming a barrier against copper diffusion comprises at least one of the materials selected from tantalum (Ta), titanium (Ti), tantalum nitride (TaN), titanium nitride (TiN), tungsten (W), tungsten titanate (TiW) and tungsten nitride or carbide (WCN).

10. Coating method according to Claim 9, **characterized in that** the surface forming a barrier against copper diffusion consists of a tantalum/tantalum nitride/tantalum trilayer or a tantalum nitride/tantalum bilayer or a titanium nitride layer.
